# EUROPEAN PATENT APPLICATION

(11) **EP 2 615 653 A1**
(43) Date of publication of application: **17.07.2013**
(21) Application number: 11823404.6
(22) Date of filing: 23.08.2011
(51) Int. Cl.: H01L 33/62, F21S 2/00, H05K 1/02, H05K 3/00

(54) **LED WIRING BOARD AND LIGHT IRRADIATION APPARATUS**

(30) Priority: 07.09.2010 JP 2010199525
(71) Applicant: CCS Inc., Kyoto-City, Kyoto 602-8011 (JP)
(72) Inventor: MIURA, Kenji, Kyoto-city Kyoto 602-8011 (JP)
(74) Representative: Müller - Hoffmann & Partner
(86) International application number: PCT/JP2011/068908
(87) International publication number: WO 2012/032925

(57) **Abstract**

It is an object of the present invention to permit division of an LED wiring board into various sizes to permit its use before and after the division, and also simplify operation of this division and simplify circuit design. More specifically, in the present invention, wiring patterns (P4) and (P5) for energizing LEDs (21) are formed in a planar direction of the LED wiring board (2). Division grooves (2M) for dividing the LED wiring board 2 into a plurality of sub-boards are formed on the front surface of the LED wiring board (2) in a perpendicular direction and are provided in a manner such as to cross the wiring patterns (P4 and P5) in the planar direction. Use with the entire board before the division by the division grooves (2M) is possible, and use with division elements divided along any of the division grooves 2M is also possible.

## Description

### Technical Field

The present invention relates to an LED wiring board loaded with an LED and a light irradiation apparatus using the LED wiring board.

### Background Art

A light irradiation apparatus, for example, a surface light source device includes: an LED wiring board loaded with LEDs; and a casing storing the LED wiring board. For this light irradiation apparatus, those of various sizes are prepared in accordance with intended illumination purposes.

However, the preparation of the light irradiation apparatuses of the various sizes requires preparation of LED wiring boards suitable for the corresponding sizes. This raises a problem that manufacturing costs of the LED wiring boards, which results in an increase in manufacturing costs of the light irradiation apparatuses. To cut the LED wiring boards of the various sizes, tools for the respective sizes are assumed to be prepared, but there is also a problem that it is difficult to provide the tools for the respective sizes in terms of, for example, costs.

On the other hand, it is also possible to prepare a plurality of unit boards forming an LED wiring board and combining together theses unit boards so as to prepare the light irradiation apparatuses of the various sizes. At this point, the plurality of unit boards are connected together by jumper wiring to ensure common lines such as a power wire and a ground wire.

However, operation of the jumper-wiring of each unit board is complicated, which causes an increase in assembly man hours and a problem of wire connection failure, leaving a concern of deteriorated yield rate.

As shown in Patent Literature 1, possible is a board for a programmable controller horizontally forming a plurality of unit board parts in parallel with a separable delinking part in between. On this board, a slit extending in an anterior-posterior direction with respect to a print wiring board is formed excluding a portion where a connecting wire is provided, whereby the delinking part is provided.

However, since the delinking part is formed by the slit, served as a portion where a connecting wire is provided is only the delinking part as a narrow width part coupling together the unit board parts. This raises a problem that circuit design needs to be made with a wiring pattern in alignment with the delinking part. This results in a more significant problem with a more complicated wiring pattern. There is also a problem that upon cutting of the delinking part, when a tool is used, preparation of a desiccated tool in correspondence with each designated size as described above. In a case where the user manually performs the cutting without using the tool, there arises a problem that it is difficult to cut it linearly.

### Citation List

### Patent Literature

Patent Literature 1: JP-A-No.2008-299594

### Summary of Invention

### Technical Problem

The present invention therefore has been made to solve the problem described above, and it is a main object thereof to not only permit division of an LED wiring board into various sizes but also permit its use before and after the division, and also simplify operation of dividing the LED wiring board and simplify circuit design.

### Solution to Problem

An LED wiring board according to the present invention has LEDs loaded on a front surface thereof. Wiring patterns for energizing the LEDs are formed in a planar direction of the LED wiring board. Division grooves for dividing the LED wiring board into a plurality of sub-boards are formed on at least one of the front surface or a rear surface of the LED wiring board in a perpendicular direction and are also provided in a manner such as to cross the wiring patterns in the planar direction. Use with the entire board before the division by the division groove is possible, and use with division elements divided along any of the division grooves is also possible.

Since the division grooves formed on the LED wiring board are provided in a manner such as to cross the wiring pattern, the wiring pattern is not cut in the planar direction by the division grooves, use with the entire board before the division is possible, and use with the division elements after the division is also possible. Therefore, various sizes of division elements can created from one LED wiring board, manufacturing of light irradiation apparatuses of various sizes can be achieved by dividing one LED wiring board, which permits reduction in manufacturing costs of the light irradiation apparatuses. Moreover, since the division grooves are provided in a manner such as to cross the wiring patterns, the wiring patterns are not limited by the division grooves in the planar direction, and it is also possible to simplify circuit design of the wiring patterns (for example, the wires can be thickened in the planar direction to reduce a resistance value as soon as possible). Further, with the division grooves, operation of cutting the LED wiring board can be simplified. That is, the division grooves function as guides for guiding cutting blades, which can therefore simplify division operation upon performance of cutting operation while moving the LED wiring board by the user.

To permit use with any way of division of the LED wiring board by use of a plurality of division grooves, it is desirable that an external connection terminal be provided at each of division unit elements as minimum units in which the division by the division grooves is done, and that the wiring patterns be formed in a manner such that by the external connection terminal of any one of the division unit elements, not only this division unit element but also the other division unit elements continuing to the aforementioned division unit element can be energized.

As a detailed embodiment of the wiring patterns or the like, it is desirable that the division grooves be formed on the front surface or a rear surface of the LED wiring board, that a power wiring pattern or a ground wiring pattern is formed on the substantially entire surface opposite to the front surface or the rear surface of the LED wiring board, and that the power wiring pattern and the ground wiring pattern are common wiring patterns electrically connecting together the division unit elements, and also the external connection terminal is provided at a portion corresponding to each of the division unit elements. With this, the division grooves are formed on one of the front surface and the rear surface of the LED wiring board and the wiring patterns are formed on the other, which permits the division grooves to be formed in a perpendicular direction as deeply as possible, making it easier to perform the division by use of the division grooves.

Specifically, it is desirable that the division grooves be formed on the front surface of the LED wiring board, and that the power wiring pattern and the ground wiring pattern are formed on the entire rear surface of the LED wiring board. Conventionally, to connect together a plurality of wiring boards on rear surfaces, this connection is achieved by solder jumper, but the rear surfaces of the boards are unleveled by the jumper, leading to failure to perform bonding to the casing with a two-sided tape or the like. On the other hand, in a case where a common line is formed on the rear surface of the board by the solder jumper, a pitch of the LEDs loaded on the front surface increases. As a result of this, the both problems described above can be solved by forming the power wiring pattern and the ground wiring pattern on the rear surface of the board as in the present invention.

To simply achieve the configuration described above, to provide general-purpose properties for use as a light irradiation apparatus, it is desirable that the division unit elements of the LED wiring board as the minimum units in which the division by the division grooves is done have the same shapes in a planar view.

It is desirable that the number of LEDs with which difference between a supply voltage and a sum of forward voltages when the LEDs are serially connected together falls in a predetermined permitted range be defined as an LED unit number, and that the number of LEDs loaded on each of the division unit elements as minimum units in which the division by the division grooves is done be defined as a common multiple of the LED unit numbers defined for the respective LEDs with the different forward voltages. With such a LED wiring board, where the number of LEDs loaded on the division unit element is defined as a common multiple of the LED unit numbers defined for the respective different kinds of LEDs, for the different kinds of LEDs, the same number of LEDs loaded on the division unit element can be provided, and for the division unit elements loaded with the different kinds of LEDs, the same size can be provided. Moreover, to manufacture light irradiation apparatuses with different kinds of LEDs, the same casing can be used as a casing storing the division unit elements. As a result of this, in the manufacturing of light irradiation apparatuses, components such as the division unit elements and the casing can be commonalized, permitting reduction in the number of components and manufacturing costs.

To improve general-purpose properties by not only providing the same sizes of LED wiring boards but also decreasing their sizes as much as possible, it is desirable that the number of LEDs loaded on each of the division unit elements is defined as a minimum common multiple of the LED unit numbers defined for the respective LEDs with the different forward voltages.

If the LED loaded on the division unit element is a surface-mounting (chip-type) LED, an optical lens needs to be provided in front of the LED. At this point, in accordance with the number of LEDs loaded on the division unit element, a dedicated optical lens needs to be prepared. According to the present invention, upon loading the surface-mounting type LEDs on the division unit elements, this number is defined as a common multiple of the LED unit numbers and the same number of LEDs to be loaded is provided even for the different kinds of LEDs, thereby permitting use of a common optical lens, which can provide even more remarkable effects of the present invention.

Moreover, a light irradiation apparatus according to the present invention includes: an LED wiring board having LEDs loaded on a front surface thereof; and a casing having a board storage space for storing the LED wiring board. The LED wiring board is formed with wiring patterns for energizing in a planar direction of the LED wiring board. Division grooves for dividing the LED wiring board into a plurality of sub-boards are formed on at least one of the front surface and a rear surface of the LED wiring board in a perpendicular direction and are also provided in a manner such as to cross the wiring patterns in a planar direction. The LED wiring board is divided for use in accordance with a size of the casing. With such a light irradiation apparatus, the LED wiring board can be divided for use in accordance with the size of the casing, thus requiring no preparation of the LED wiring board for each size of the casing, which permits use of a common LED wiring board in manufacturing of light irradiation apparatuses and thus permits reduction in the number of components and manufacturing costs.

In a case where the LED wiring board is divided for use, that is, in a case where the division element is stored in the board storage space of the casing, part of the wiring pattern is possibly exposed on the side surface of the division element. This involves in a risk that short occurs as a result of contact between the side surface of the division element and the inner surface of the casing. To solve this problem, the LED wiring board is arranged in a manner such that a side surface of the LED wiring board is separated from the inner surface of the casing in a state in which the LED wiring board is stored in the board storage space.

Upon the storage of the LED wiring board in the casing, in view of heat dissipation of this LED wiring board, the LED wiring board needs to be firmly attached to, for example, a bottom wall of the casing or a heat conducting member provided at the bottom wall. Here, in a case where the division groves are provided on the rear surface of the LED wiring board, there arises a problem that the LED wiring board is curved towards the rear surface side, making it difficult to firmly attach a central part of the LED wiring board to the casing. Thus, it is desirable that wherein the division groove is formed on only the front surface of the LED wiring board. As a result of this, the LED wiring board is curved towards the front surface side, which can simplify operation of firmly attaching the LED wiring board to the casing and can also ensure adhesiveness.

Further, for a method of cutting an LED wiring board according to the present invention, the division grooves are v-shaped grooves having a V shape in cross section, the LED wiring board is cut by using a pair of rotary cutting blades of a circular-plate-like shape whose blade tips are arranged oppositely to each other and also by making relative movement of the LED wiring board and the pair of rotary cutting blades in a manner such that the V-shaped groove of the LED wiring board engages with the rotary cutting blades. This can not only simplify positioning between the rotary cutting blades and the V-shaped groove and cutting operation as a result of engagement between blade tips of the rotary cutting blades and the V-shaped groove but also improve cutting accuracy. Advantageous Effects of Invention

According to the present invention configured as described above, it is possible to permit division of the LED wiring board into various sizes and permit its use before and after the division, and also simplify operation of dividing the LED wiring board.

### Brief Description of Drawings

[FIG. 1] FIG. 1 is a perspective view of a light irradiation apparatus according to one embodiment of the present invention.
[FIG. 2] FIG. 2 is a sectional view of the light irradiation apparatus according to the same embodiment.
[FIG. 3] FIG. 3 is a partial plan view of an LED wiring board (before division) on which LEDs are loaded according to the same embodiment.
[FIG. 4] FIG. 4 is a schematic partial sectional view of the LED wiring board according to the same embodiment.
[FIG. 5] FIG. 5 is a diagram partially showing an LED mounting wiring pattern according to the same embodiment.
[FIG. 6] FIG. 6 is a diagram partially showing a first internal wiring pattern according to the same embodiment.
[FIG. 7] FIG. 7 is a diagram partially showing a second internal wiring pattern according to the same embodiment.
[FIG. 8] FIG. 8 is a partial plan view showing a resist film on a front surface of the LED wiring board according to the same embodiment.
[FIG. 9] FIG. 9 is a diagram partially showing a power wiring pattern and a ground wiring pattern according to the same embodiment.
[FIG. 10] FIG. 10 is a partial plan view showing a resist film on a rear surface of the LED wiring board according to the same embodiment.
[FIG. 11] FIG. 11 is a diagram showing a method of cutting the LED wiring board according to the same embodiment.
[FIG. 12] FIG. 12 is a circuit line diagram in a case where red LEDs are loaded.
[FIG. 13] FIG. 13 is a circuit line diagram in a case where white LEDs are loaded.
[FIG. 14] FIG. 14 is a circuit line diagram in a case where infrared LEDs are loaded.
[FIG. 15] FIG. 15 is a schematic partial sectional view of an LED wiring board according to a modified embodiment.
[FIG. 16] FIG. 16 is a schematic partial sectional view of an LED wiring board according to a modified embodiment.

**Reference Signs List**

| | |
|---|---|
| 100 | Light irradiation apparatus |
| 2 | LED wiring board |
| 21 | LED |
| P1 | LED-mounting wiring pattern |
| P2 | First internal wiring pattern |
| P3 | Second internal wiring pattern |
| v | Power wiring pattern |
| P5 | Ground wiring pattern |
| 2M | Division groove |
| 200 | Division unit element |
| 3 | Casing |

### Description of Embodiments

Hereinafter, one embodiment of a light irradiation apparatus 100 according to the present invention will be described with reference to the accompanying drawings.

### <Apparatus Configuration>

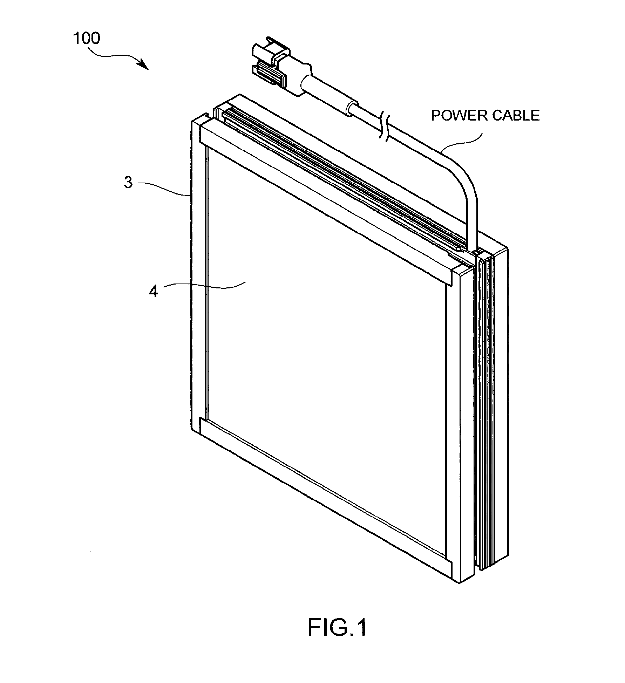

The light irradiation apparatus 100 according to the present invention, for example, irradiates light to a work in order to perform a surface test on this work, and as shown in FIG. 1, is a surface light-emitting apparatus having a light irradiation surface of a substantially rectangular shape.

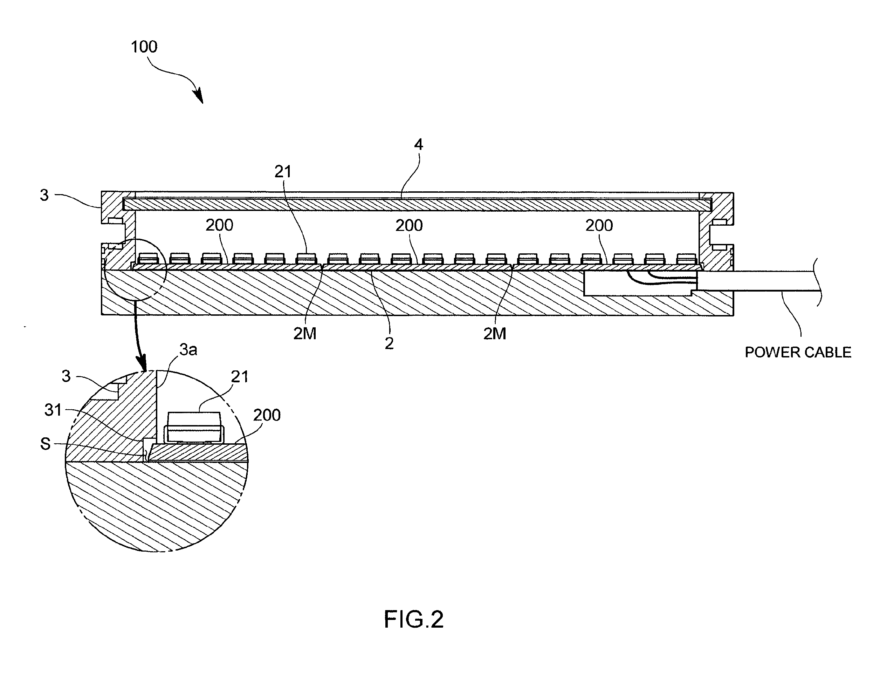

More specifically, as shown in FIGS. 1 and 2, this includes: an LED wiring board 2 loaded with a plurality of LEDs 21; and a casing 3 having a board storage space for storing this LED wiring board 2. The casing 3 has a bottomed-box-like shape having an opening at one surface. A light-transmitting member 4 such as a lens board having a diffuser plate and a lens part corresponding to each LED is provided.

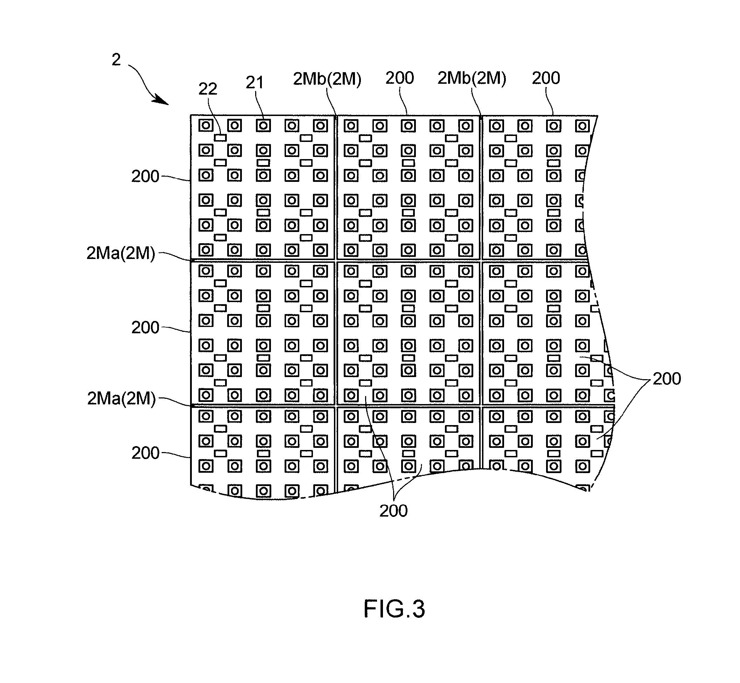

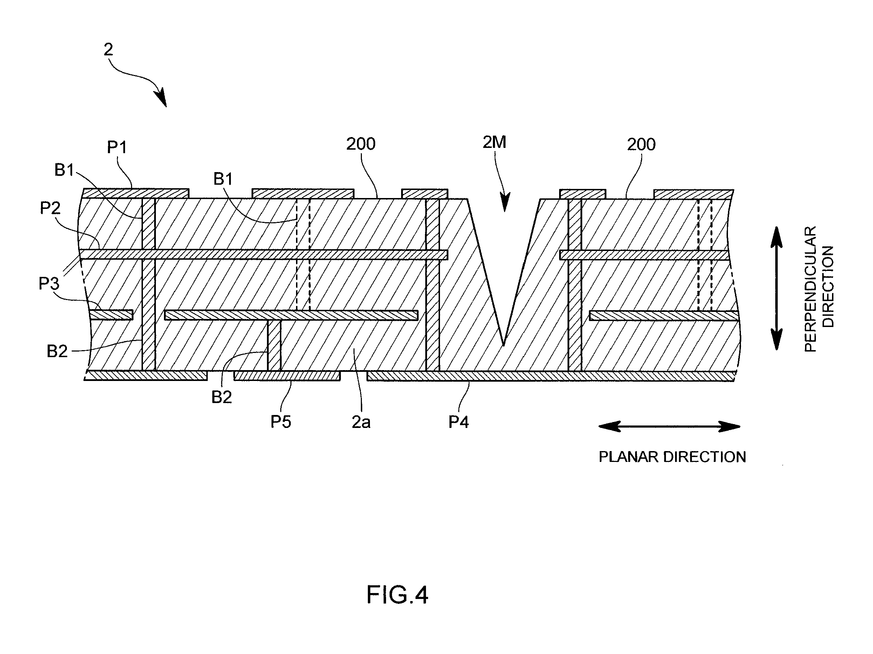

The LED wiring board 2 has a substantially rectangular shape in a planar view, and as shown in FIGS. 2 and 3, and has a plurality of surface-mounting type LEDs 21 loaded on a surface thereof. More specifically, this LED wiring board 2, as shown in FIG. 4, has wiring patterns P1 to P5 for energizing the LEDs 21 in a planar direction of the LED wiring board 2, and is a multi-layered board having an insulating base and the wiring patterns P1 to P5 superposed one on another. The wiring patterns P1 to P5 formed at the respective layers will be described below.

Moreover, as shown in FIGS. 2 and 3, division grooves 2M for dividing the LED wiring board 2 into a plurality of division unit elements 200 are formed on the LED wiring board 2. This division groove 2M, as shown in FIG. 4, has a V shape in a sectional view, and is formed perpendicularly to the front surface of the board and is also provided in a manner such as to cross, in a planar direction, of the wiring patterns P1 to P5, the wiring patterns P4 and P5 formed on the rear surface of the LED wiring board 2 or the wiring patterns P2 and P3 formed inside thereof. The division groove 2M of the present embodiment is provided in a manner such as to cross, in the planar direction, the wiring patterns P4 and P5 formed on the rear surface of the LED wiring board 2. For example, in a case where thickness of the LED wiring board 2 is, for example, 1 mm in terms of heat dissipation performance, perpendicular depth of the division groove 2M is preferably 0.5 to 0.8 mm. In a case where the depth is 0.5 mm or less, a burr tends to appear on a cut surface when the LED wiring board 2 is divided, and in a case where the depth is 0.8 mm or above, it is difficult to form the power wiring pattern and the ground wiring pattern as common lines. In this viewpoint, the division groove 2M has a depth of, for example, 0.7 mm. In the present embodiment, the division grooves 2M are formed on only the front surface of the LED wiring board 2, so that the LED wiring board 2 is curved towards a front surface side, which can simplify operation of firmly attaching the LED wiring board 2 to the casing 3 with a bonding member such as an insulating two-sided tape and also can ensure adhesiveness.

Moreover, the division grooves 2M of the present embodiment, as shown in FIG. 3, are formed of: a plurality of horizontal division grooves 2Ma provided in parallel to a horizontal side of the LED wiring board 2; and vertical division grooves 2Mb provided in parallel to a vertical side of the LED wiring board 2. The horizontal division grooves 2Ma are formed at mutually equal intervals in a manner such as to equally divide the LED wiring board 2 in a vertical direction, and the vertical division grooves 2Mb are formed at mutually equal intervals in a manner such as to equally divide the LED wiring board 2 in a horizontal direction. As described above, the division grooves 2M are formed in a manner such as to form a grid shape extending in the vertical and horizontal directions. As a result, division unit elements 200 as minimum board units in which the division by the division grooves 2M is performed have the same shapes in a planar view, and more specifically, substantially rectangular shapes (substantially square shapes in the present embodiment). Moreover, the LED wiring board 2 of the present embodiment has seven columns and nine rows of division unit elements formed by the division grooves 2M. If the division unit elements 200 have substantially square shapes, storage in the casing 3 can be achieved regardless of whether a storage direction is vertical or horizontal, which can improve operability and general-purpose properties.

Now, the wiring patterns P1 to P5 formed at the respective layers of the LED wiring board 2 will be described in view of relation to the division unit element 200.

The LED wiring board 2 of the present embodiment, as shown in FIG. 4, has: the LED-mounting wiring pattern P1 which is formed on the front surface and which forms electrode terminals for LED mounting; the power wiring pattern P4 and the ground wiring pattern P5 which are formed on the rear surface and which forms common lines; the first internal wiring pattern P2 which is provided inside the board and which electrically connects together the power wiring pattern P4 and the plus terminals of the electrode terminals; and the second internal wiring pattern P3 which electrically connects together the ground wiring pattern P5 and the minus terminals of the electrode terminals. A resistor 22 for current limiting is also mounted on the LED-mounting wiring pattern P1.

Moreover, an insulating base 2a lies between these wiring patterns P1 to P5 and they are insulated from each other. Here, the LED-mounting wiring pattern P1, the first internal wiring pattern P2, and the second internal wiring pattern P3 are electrically connected together with a via B1, and the first internal wiring pattern P2, the second internal wiring pattern P3, the power wiring pattern P4, and the ground wiring pattern P5 are electrically connected together with vias B2.

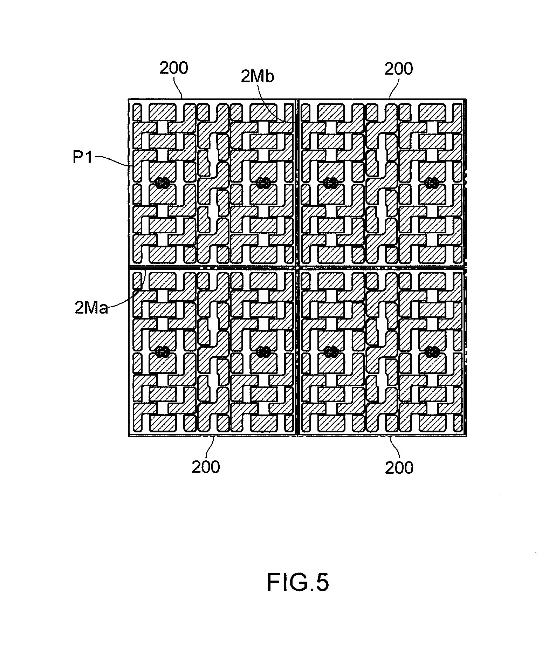

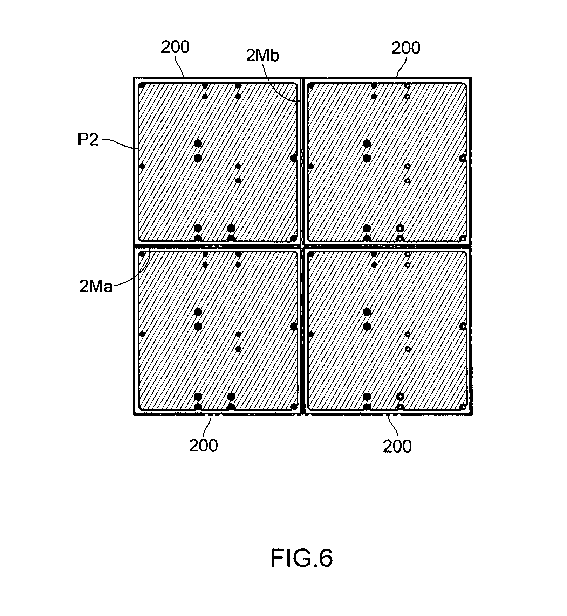

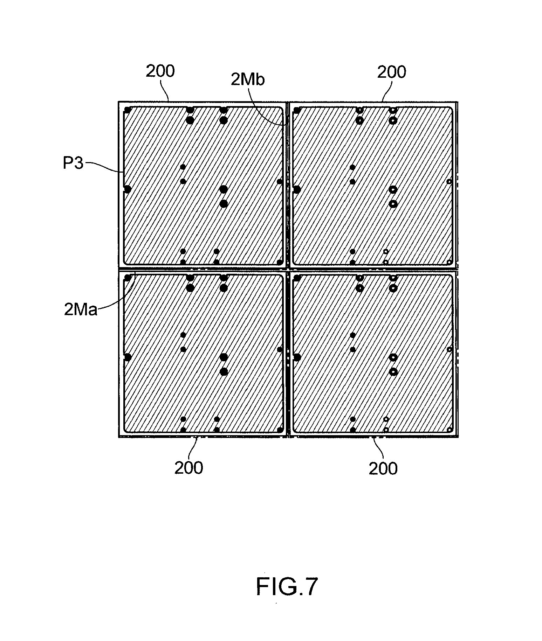

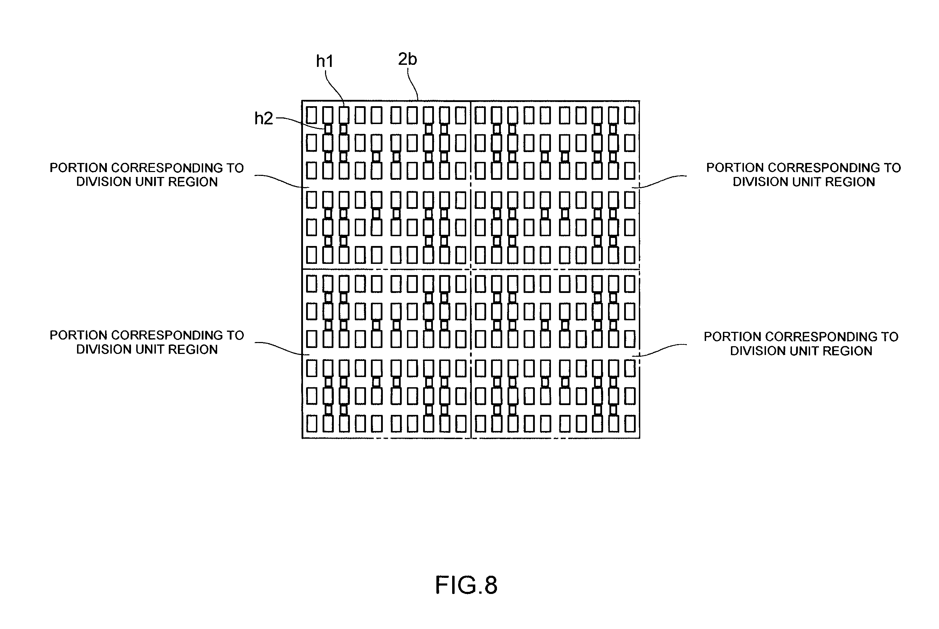

The LED-mounting wiring pattern P1, the first internal wiring pattern P2, and the second internal wiring pattern P3, as shown in FIGS. 5 to 7, are formed independently for each division unit element 200. That is, these wiring patterns P1 to P3 are formed for each of regions blocked by the division grooves 2M in a planar view. In other words, the division grooves 2M are configured in a manner such as not to cross the LED-mounting wiring pattern P1, the first internal wiring pattern P2, and the second internal wiring pattern P3. Moreover, the LED-mounting wiring pattern P1, the first internal wiring pattern P2, and the second internal wiring pattern P3 are each configured in a manner such as to have the same patterns for the different division unit elements 200. A resist film 2b for forming the electrode terminals for mounting the LEDs 21 and the resistors 22 is provided at the LED-mounting wiring pattern P1. This resist film 2b, as shown in FIG. 8, has opening parts h1 for partially exposing the LED-mounting wiring pattern P1 in order to form a predetermined number of electrode terminals (for example, 30 pairs of a plus terminal and a minus terminal) for each division unit element 200. The resist film 2b also has opening parts h2 formed in such a manner as to form the electrode terminals for resistor connection.

Here, describing perpendicular positional relationship between the division groove 2M and the LED-mounting wiring pattern P1, the first internal wiring pattern P2, and the second internal wiring pattern P3, the LED-mounting wiring pattern P1, the first internal wiring pattern P2, and the second internal wiring pattern P3 are located closer to a board front surface side than depth position of the division groove 2M (see FIG. 4).

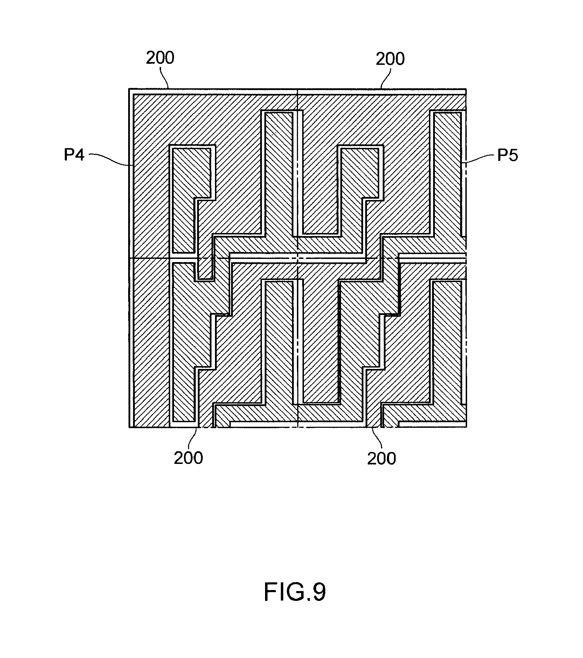

On the other hand, the power wiring pattern P4 and the ground wiring pattern P5 are, as shown in FIG. 9, continuously formed in a manner such as to link together the division unit elements 200 in order to function as common wiring patterns electrically connecting together the division unit elements 200. That is, the power wiring pattern P4 and the ground wiring pattern P5 are formed in a manner such as to cross the division groove 2M.

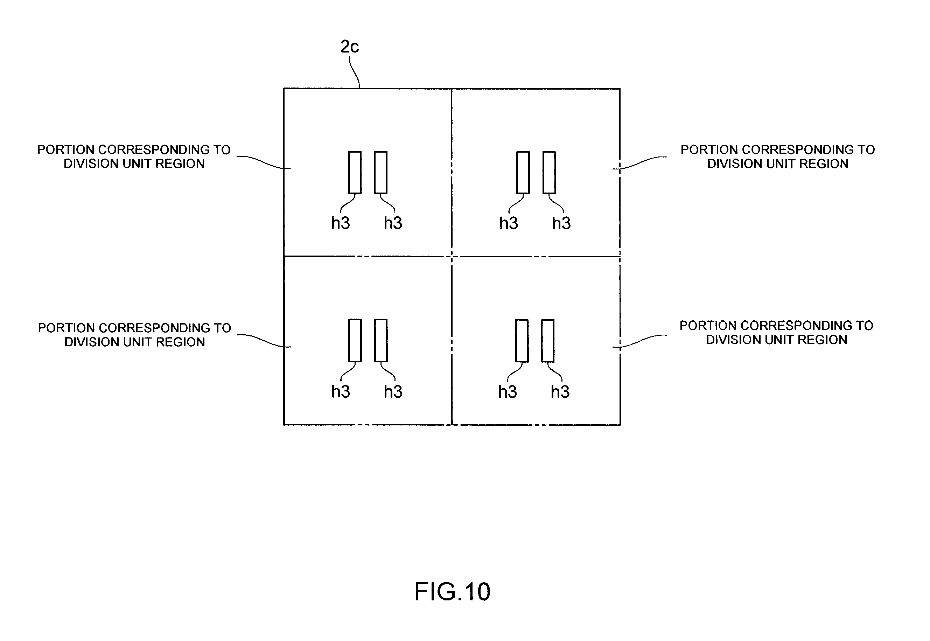

Moreover, a resist film 2c for forming external connection terminals is provided at the power wiring pattern P4 and the ground wiring pattern P5. In order to form the external connection terminal at each division unit element 200, as shown in FIG. 10, a pair of opening parts h3 for partially exposing the power wiring pattern P4 and the ground wiring pattern P5 are provided at a portion of this resist film 2c corresponding to each division unit element 200. To the external connection terminal, a power cable is connected.

With the configuration described above, the LED-mounting wiring pattern P1, the first internal wiring pattern P2, and the second internal wiring pattern P3 are separated by the division groove 2M on an individual division unit element 200 basis, but the power wiring pattern P4 and the ground wiring pattern P5 are not separated by the division groove 2M. This permits use with the entire board before the division by the division groove 2M and also permits use with the division element (one or a plurality of division unit elements 200) divided along any of the division grooves 2M. Moreover, the power wiring pattern P4 and the ground wiring pattern P5 are electrically connected to the LED-mounting wiring pattern P1 and the first and second internal wiring patterns P2 and P3 with the vias B1 and B2, which therefore makes it possible to energize, by the external connection terminal of any one of the division unit elements 200, not only the LEDs 21 loaded on the aforementioned division unit element 200 but also the LEDs 21 loaded on the other division unit elements 200 continuing to the aforementioned division unit element 200.

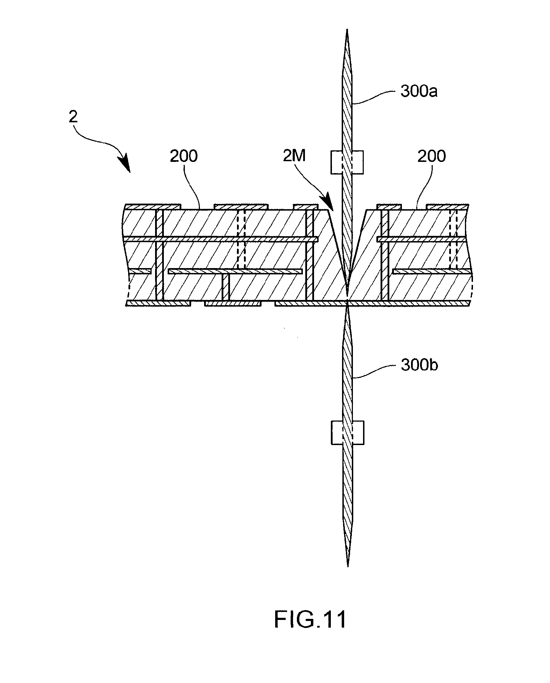

Now, one example of a method of cutting the LED wiring board 2 will be described. Used for this cutting of the LED wiring board 2 is, as shown in FIG. 11, a cutting tool having a pair of rotary cutting blades 300a and 300b of a circular-plate-like shape whose blade tips are arranged oppositely to each other. An interval between the blade tips of the rotary cutting blades 300a and 300b is set to be smaller than thickness of a bottom wall of the division groove 2M. Then passing the LED wiring board through between the rotary cutting blades 300a and 300b in rotation cuts and divides the LED wiring board 2. At this point, the division groove 2M formed at the LED wiring board 2 engages with the rotary cutting blade 300a and the LED wiring board 2 is guided along the division groove 2M by the rotary cutting blade 300a. Cutting the LED wiring board 2 by use of the cutting tool in this manner hardly causes burr on a cutting surface of a side surface of the division element, permitting smoothening and also requiring no burr removal. Although this may easily cause burr occurrence, it is also possible to manually perform the division if burr removal is to be performed after the division.

Next, relationship between the LED wiring board 2 and the casing 3 storing this will be described.

In a case where the LED wiring board 2 with the configuration described above is divided for use, that is, in a case where the division elements are stored in a board storage space of the casing 3, part of the wiring patterns, more specifically, cutting surfaces of the power wiring pattern P4 and the ground wiring pattern P5 are exposed at the side surface of the division element. A sectional view of FIG. 2 shows the light irradiation apparatus 100 using division elements formed of three vertical and three horizontal division units. Therefore, in the present embodiment, in a state in which the division element is stored in the storage space, the side surface of the division element is arranged in a manner such as to be separated from an inner surface 3a of the casing 3. More specifically, as shown in the partially enlarged view of FIG. 2, a concave portion 31 concaved laterally in order to form a gap S between the inner surface 3a and the side surface of the division element is formed on the inner surface 3a of the casing 3. This concave portion 31 provides configuration such that the inner surface of the casing 3 does not make contact with the side surface of the division element. In addition, the inner surface (including a bottom surface and the side surface) of the casing 3 is subjected to insulation alumite treatment, which ensures insulation performance between the stored LED wiring board 2 (division elements) and the casing 3.

However, the number of LEDs 21 loaded on the division unit element 200 of the present embodiment is a least common multiple of LED unit numbers defined for the respective different kinds of LEDs 21. The different kinds of LEDs 21 include, for example, not only LEDs emitting light of different wavelengths but also LEDs emitting light of the same wavelengths but having different numbers of LED elements disposed in a package. In any case, it is desirable that the packages of the different kinds of LEDs 21 have the same shapes. Moreover, a way of determining the number of LEDs 21 loaded on the division unit elements 200 is effective only for a case where a plurality of LEDs 21 is voltage-controlled.

Here, the "LED unit number" is the number of LEDs 21 whose difference (V_{E}-V_{f}× N) between a supply voltage V_{E} and a sum of forward voltages V_{f} when the LEDs 21 are serially connected together (V_{f} × N) falls in a predetermined permitted range, and the number of LEDs 21 serially connected to the supply voltage V_{E}.

The forward voltage V_{f} of the present embodiment is a forward voltage for each packaged LED 21. Moreover, the "predetermined permitted range" is determined by a condition that a desired irradiation region can be realized by one or a plurality of division unit elements 200 in a case where the LEDs 21 are loaded on the division unit elements 200 based on the common multiple of the LED unit numbers defined for the respective different kinds of LEDs 21 (more specifically, condition that a minimum common multiple of the LED unit numbers defined for the different kinds of LEDs 21 is decreased as much as possible), and a condition that the LED unit numbers for the respective different kinds of LEDs 21 are increased as much as possible.

For example, a case where a light irradiation apparatus 1 is incorporated into an FA (factory automation), that is, a case where the supply voltage V_{E} is a direct voltage of 24V, and a case where three kinds of light irradiation apparatuses 100 with red LEDs 21, white LEDs 21, and infrared LEDs 21 are manufactured will be described.

The forward voltage V_{f} of the red LED 21 is approximately 2.2V, and the number of red LEDs 21 that can be serially connected to the supply voltage V_{E} is 10. That is, the LED unit number of the red LEDs 21 is 10.

Moreover, the forward voltage V_{f} of the white LED 21 is approximately 3.3V, and the number of white LEDs 21 that can be serially connected to the supply voltage V_{E} is 6. That is, the LED unit number of the white LEDs 21 is six. Another possible number of white LEDs 21 that can be serially connected is seven, but considering relationship with the LED unit numbers of the other kinds of LEDs 21, it is set at a value that decreases the minimum common multiple as much as possible.

Further, the forward voltage V_{f} of the infrared LED 21 is approximately 1.5V, and the number of infrared LEDs 21 that can be serially connected to the supply voltage V_{E} is 15. That is, the LED unit number of the infrared LEDs 21 is 15.

Thirty which is a minimum common multiple of the LED unit number of the red LED 21 (10), the LED unit number of the white LED 21 (6), and the LED unit number of the infrared LED 21 (15) is defined as the number of LEDs 21 loaded on each division unit element 200.

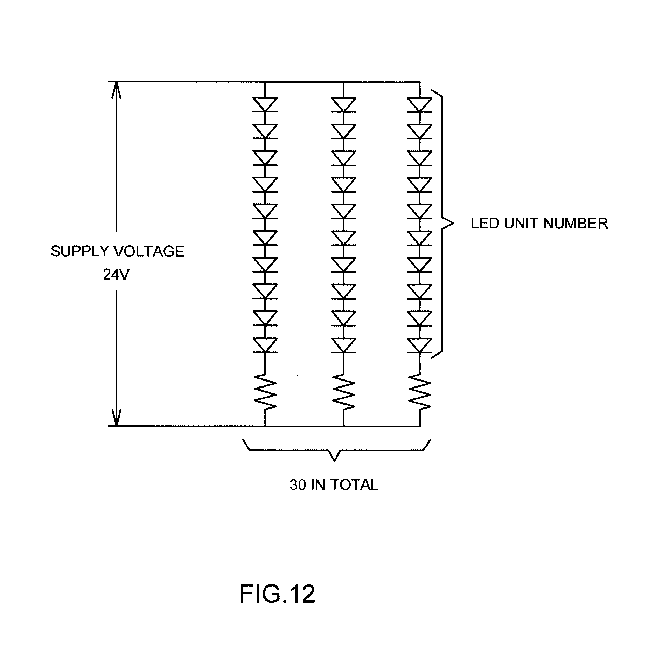

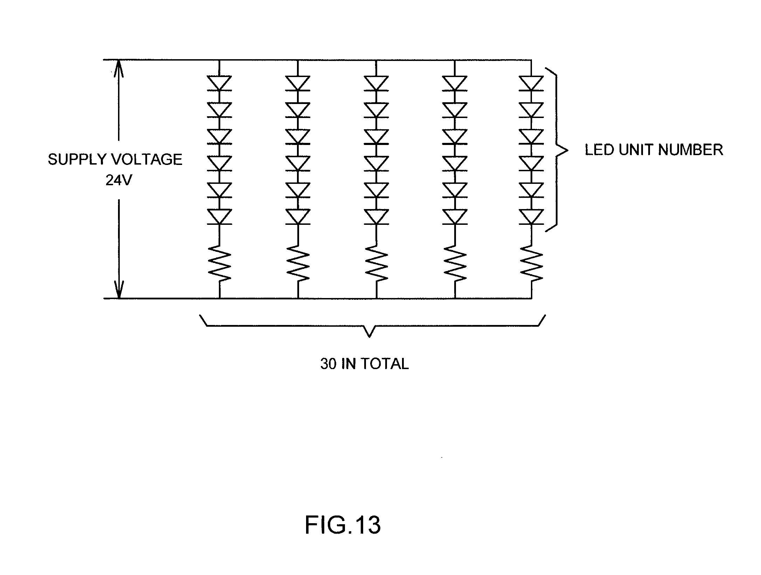

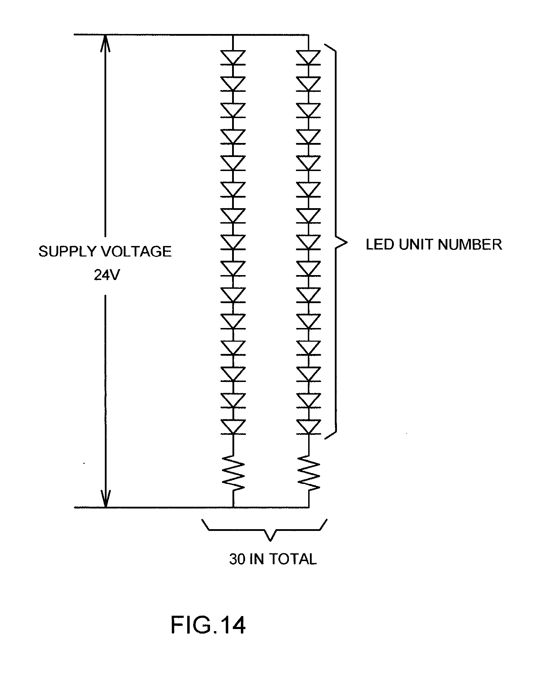

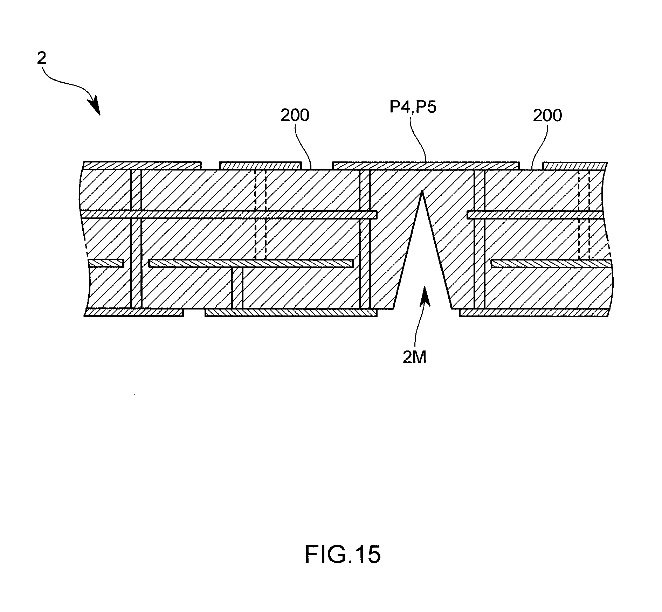

As a way of connecting together the LEDs 21 on the circuit, the number of LEDs 21 corresponding to the LED unit number are serially connected together and these serially connected LED groups are parallelly connected together to provide the minimum common multiple. That is, for the red LEDs 21, as shown in FIG. 12, ten red LEDs 21 are serially connected together to form a red LED group, and the red LEDs 21 are parallelly connected together (that is, three columns of red LED groups) so that a total number of red LEDs 21 becomes 30. Moreover, for the white LEDs 21, as shown in FIG. 13, six white LEDs 21 are serially connected together to form a white LED group, and the white LEDs 21 are parallelly connected together (that is, five columns of white LED groups) so that a total number of white LEDs 21 becomes 30. Furthermore, for the infrared LEDs 21, as shown in FIG. 14, 15 infrared LEDs 21 are serially connected together to form an infrared LED group, and the infrared LEDs 21 are parallelly connected together (that is, two columns of infrared LED groups) so that a total number of infrared LEDs 21 becomes 30. In order to achieve the parallel connection as described above, the wiring patterns P1 to P5 of the LED wiring board 2 used for each color are formed.

A way of arranging the LEDs 21 on the division unit element 200 is the same between the LED boards 2 of the respective colors, and as described above, as shown in FIG. 3, the LEDs 21 are arranged in a matrix form (six columns and five rows in the present embodiment) with their optical axes aligned in a substantially fixed direction).

### <Effects of the Invention]

With the light irradiation apparatus 100 configured as described above according to the present embodiment, the division grooves 2M formed on the LED wiring board 2 are provided in a manner such as to cross the power wiring pattern P4 and the ground wiring pattern P5, which therefore permits usage with the entire board before the division without cutting the wiring patterns P4 and P5 in a planar direction by the division groove 2M and also permits use even with the division elements after the division. Therefore, the division elements of various sizes can be made from one LED wiring board 2, and manufacture of light irradiation apparatuses 100 of various sizes can be achieved by dividing one LED wiring board 2, permitting reduction in manufacturing costs of the light irradiation apparatuses 100.

Moreover, since the division grooves 2M are provided in a manner such as to cross the wiring patterns P4 and P5, the wiring patterns P4 and P5 are not limited in the planar direction by the division grooves 2M, which also makes it possible to simplify circuit design of the wiring patterns P4 and P5, for example which can thicken the wires in the planar direction to decrease resistance values as much as possible.

Further, with the division grooves 2M, operation of cutting the LED wiring board 2 can be simplified. That is, the division groove 2M functions as a guide for guiding the cutting blade, which can simplify division operation in a case where the cutting operation is performed while the user manually moves the LED wiring board 2.

Furthermore, where the number of LEDs 21 loaded on the division unit element 200 can be set as a common multiple of the LED unit numbers defined for the respective different kinds of LEDs, for the different kinds of LEDs 21, the same number of LEDs to be loaded on the division unit elements 200 can be provided, and thus the same size can be provided for the division unit elements 200 loaded with the different kinds of LEDs 21. Moreover, in a case where a light irradiation apparatus 100 using different kinds of LEDs 21, the same casing 3 for storing the division unit elements 200 can be used. This can, in manufacture of the light irradiation apparatus 100, commonalize components such as the division unit elements 200 and the casing 3, permitting reduction in the number of components and also reduction in manufacturing costs.

### <Other Modified Embodiments>

Note that the present invention is not limited to the embodiments described above.

For example, the LED wiring board of the embodiment described above is a multilayered board having the wiring patterns formed on the two surfaces and the inside of the insulating base, but may be a multilayered board having the wiring patterns formed on one of the surfaces and the inside of the insulating board. It may be, instead of the multilayered board, a one-sided board having the wiring patterns formed on one surface of the insulating base or a two-sided board having the wiring patterns formed on the two surfaces of the insulating which two surfaces are connected together by a through hole.

Moreover, the division grooves of the embodiment described above is formed on the front surface of the LED wiring board 2, and the power wire and the ground wire are formed on the rear surface of the LED wiring board, but they may be formed inside of the LED wiring board 2 in a manner such as not to cross the division grooves in a perpendicular direction.

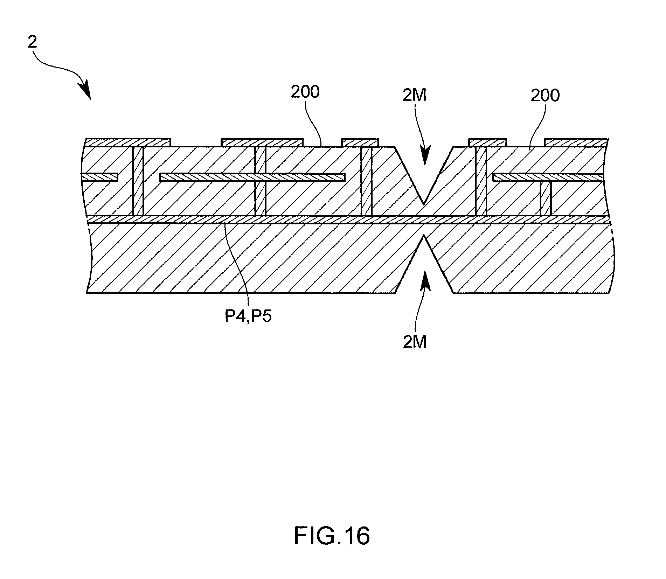

Further, as shown in FIG. 15, the division grooves 2M may be formed on the rear surface of the LED wiring board 2. In this case, the power wiring pattern P4 and the ground wiring pattern P5 are formed on the front surface of the LED wiring board 2 or the inside of the board 2. In a case where the power wiring pattern P4 and the ground wiring pattern P5 are formed inside, they are formed in a manner such as not to cross the division grooves 2M in the perpendicular direction. Moreover, as shown in FIG. 16, in the case where the power wiring pattern P4 and the ground wiring pattern P5 are formed inside, the division grooves 2M may be formed on the front surface and the rear surface of the LED wiring board 2 in a manner such as to oppose each other.

In addition, in the embodiment described above, the wiring patterns which the division grooves cross are the power wiring pattern and the ground wiring pattern, but they may cross the different wiring patterns.

Furthermore, the embodiment described above is applied to a surface light-emitting apparatus for test use, but it is not limited for test use and may be applied to illumination apparatuses for general use. Moreover, it may be applied not only to the surface light-emitting apparatuses but also to line light irradiation apparatuses.

In addition, the LED of the embodiment described above is a surface-mounting LED but may be of a shot-type.

In addition, a sectional shape of the division groove may be not only a V shape in cross section but also a semicircle or an upwardly U shape in cross section.

The present invention is not limited to the embodiment described above, and various modifications are possible within a range not departing from spirits of the present invention.

### Industrial Applicability

The present invention permits division of the LED wiring board into various sizes, permits use before and after the division, and also can simplify operation of dividing the LED wiring board.

## Claims

1. An LED wiring board having LEDs loaded on a front surface thereof,
wherein
wiring patterns for energizing the LEDs in a planar direction of the LED wiring board is formed,
division grooves for dividing the LED wiring board into a plurality of sub-boards are formed on at least one of the front surface or a rear surface of the LED wiring board in a perpendicular direction, and are also provided in a manner such as to cross the wiring patterns in the planar direction, and
use with the entire board before the division by the division groove is possible, and use with division elements divided along any of the division grooves is also possible.

2. The LED wiring board according to claim 1, wherein
an external connection terminal is provided at each of division unit elements as minimum units in which the division by the division grooves is done, and
the wiring patterns are formed in a manner such that by the external connection terminal of any one of the division unit elements, not only this division unit element but also the other division unit elements continuing to the aforementioned division unit element can be energized.

3. The LED wiring board according to claim 2, wherein
the division grooves are formed on the front surface or a rear surface of the LED wiring board,
a power wiring pattern or a ground wiring pattern is formed on the substantially entire surface opposite to the front surface or the rear surface of the LED wiring board, and
the power wiring pattern and the ground wiring pattern are common wiring patterns electrically connecting together the division unit elements, and also the external connection terminal is provided at a portion corresponding to each of the division unit elements.

4. The LED wiring board according to claim 3, wherein
the division grooves are formed on the front surface of the LED wiring board, and
the power wiring pattern and the ground wiring pattern are formed on the entire rear surface of the LED wiring board.

5. The LED wiring board according to 1, wherein
the division unit elements as the minimum units in which the division by the division grooves is done have the same shapes in a planar view.

6. The LED wiring board according to claim 1, wherein
the division grooves are V-shaped grooves each having a V shape in cross section.

7. The LED wiring board according to claim 6, wherein
the V-shaped grooves have depth equal to half or more of thickness of the LED wiring board.

8. The LED wiring board according to claim 6, wherein
the depth of the division grooves is 0.5 mm to 0.8 mm where the thickness of the LED wiring board is 1 mm.

9. The LED wiring board according to claim 1, wherein
the number of LEDs with which difference between a supply voltage and a sum of forward voltages when the LEDs are serially connected together falls in a predetermined permitted range is defined as an LED unit number, and
the number of LEDs loaded on each of the division unit elements as minimum units in which the division by the division grooves is done is defined as a common multiple of the LED unit numbers defined for the respective LEDs with the different forward voltages.

10. The LED wiring board according to claim 9, wherein
the number of LEDs loaded on each of the division unit elements is defined as a minimum common multiple of the LED unit numbers defined for the respective LEDs with the different forward voltages

11. The LED wiring board according to claim 9, wherein
the LEDs are surface-mounting LEDs.

12. An light irradiation apparatus comprising:
an LED wiring board having LEDs loaded on a front surface thereof; and
a casing having a board storage space for storing the LED wiring board,
wherein in the LED wiring board, wiring patterns for energizing the LEDs are formed in a planar direction of the LED wiring board, and division grooves for dividing the LED wiring board into a plurality of sub-boards are formed on at least one of the front surface and a rear surface of the LED wiring board in a perpendicular direction and are also provided in a manner such as to cross the wiring patterns in a planar direction, and
the LED wiring board is divided for use in accordance with a size of the casing.

13. The light irradiation apparatus according to claim 12, wherein
the LED wiring board is arranged in a manner such that a side surface of the LED wiring board is separated from an inner surface of the casing in a state in which the LED wiring board is stored in the board storage space.

14. The light irradiation apparatus according to claim 12, wherein
the division groove is formed on only the front surface of the LED wiring board.

15. A method of cutting the LED wiring board according to claim 5, the method
cutting the LED wiring board by using a pair of rotary cutting blades of a circular-plate-like shape whose blade tips are arranged oppositely to each other and also by making relative movement of the LED wiring board and the pair of rotary cutting blades in a manner such that the V-shaped groove of the LED wiring board engages with the rotary cutting blades.
